Europäisches Patentamt

European Patent Office

Office européen des brevets

(19)

(11) Publication number : **0 506 832 B1**

# EUROPEAN PATENT SPECIFICATION

(12)

(45) Date of publication of patent specification :
**13.04.94 Bulletin 94/15**

(51) Int. Cl.⁵ : **G06F 15/74,** G06F 11/22, F02D 41/24

(21) Application number : **91902167.5**

(22) Date of filing : **13.12.90**

(86) International application number :
**PCT/EP90/02182**

(87) International publication number :
**WO 91/10205 11.07.91 Gazette 91/15**

(54) METHOD AND DEVICE FOR STORING INTERMITTENT FUNCTIONAL FAULTS OF A PHYSICAL SYSTEM AND OF CONTEXT VARIABLES OF THESE FAULTS.

(30) Priority : **21.12.89 FR 8916968**

(43) Date of publication of application :
**07.10.92 Bulletin 92/41**

(45) Publication of the grant of the patent :
**13.04.94 Bulletin 94/15**

(84) Designated Contracting States :
**DE GB IT**

(56) References cited :
**DE-C- 3 829 546
US-A- 3 369 222
US-A- 3 725 880
US-A- 4 602 127
PROCEEDINGS OF THE 20TH ANNUAL ISA (INSTRUMENT SOCIETY OF AMERICA) CONFERENCE, VOLUME 20, PART III, 9.3-4-65, 4-7 OCTOBER 1965, H.W. SIGMON ET AL.: "A TECHNIQUE FOR TRAPPING AND STORING INTERMITTENT ERROR CONDITIONS", PAGES 1-4**

(56) References cited :
**NUCLEAR INSTRUMENT & METHODS IN PHYSICS RESEARCH, VOLUME 220, NO. 2,3, MARCH 1984, ELSEVIER SCIENCE, PUBLISHERS B.V. (AMSTERDAM, NL), W.R. FALK: "DATA REDUCTION FROM EXPERIMENTAL HISTOGRAMS", PAGES 473-478 SPACE SCIENCE INSTRUMENTATION, VOLUME 5, NO. 3, JULY 1981, D. REIDEL PUBLISHING CO., (DORDRECHT, NL) S. BEROS: "MICROCOMPUTER ON-LINE DATA REDUCTIONS FOR SATELLITE EXPERIMENTS", PAGES 247-256**

(73) Proprietor : **SIEMENS AKTIENGESELLSCHAFT
Wittelsbacherplatz 2
D-80333 München (DE)**

(72) Inventor : **POURNAIN, Michel, André
6, rue de Bocage
F-31490 Léguevin (FR)**
Inventor : **SALAFIA, Dominique
4, rue des Fougères
F-31170 Tournefeuille (FR)**

EP 0 506 832 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method and to a device for storing intermittent functional faults of a physical system and for storing variables defining the context of these faults. Such a device is preferably destined to be installed in a motor vehicle and designed to supply data relating to the causes of the stored faults to a diagnostic device.

Present day motor vehicles comprise electronic devices which are more and more complex and ever increasing in number in order to ensure various monitoring and control functions of the engine, the transmission, the suspension, the braking, the motor function, the passenger compartment temperature, etc...

These electronic devices are subject to permanent or intermittent failures for which it is necessary to identify the causes in order to allow the repair of the systems, sub-systems or units which are affected by them.

For this purpose the electronic controllers at present used in these devices currently comprise means allowing them to ensure self-diagnostic functions enabling the detection of the incorrect functioning of an electronic component or of a peripheral unit of the controller (sensor, actuator, etc...). Such permanent or intermittent failures are stored by the controller itself and the data thus stored are then transmitted, while the vehicle is in the garage, to a computer installed in the garage and provided with means for diagnosis of various failures which can affect the onboard electronic devices.

The recording of permanent or intermittent failures suffered by such and such a unit, subassembly or functional assembly forming part of the vehicle does not always constitute sufficient data for diagnosing the origin of the failure, particularly when the latter is intermittent and likely not to manifest itself during an inspection of the vehicle in the garage. It would therefore be very useful to know the context in which the intermittent failures appeared in order to reveal possible correlations between certain parameters defining this context and the appearance of the failure. Such correlations can allow the identification of the causes of the failure and then the application of the remedy for this failure.

A known technique for trapping and storing intermittent error conditions is designed for storing functional faults of a physical system and for storing variables defining the context of these faults. Thereby readings are taken, in a time window surrounding the presence of a predetermined fault, of predetermined context variables, the variables being stored and the stored variables being updated at each of the successive manifestations of the intermittent fault (Proceedings of the 20th Annual ISA CONFERENCE, vol. 20, part III, 9.3-4-65, 4 - 7 October 1965, pages 1 - 4, H.W. Simon et al: "A technique for trapping and storing intermittent error conditions"). This technique, however, does not take samples but records analogue signals and does not process the acquired signals to derive a reduced form of a data set associated with each of the context variables, nor does it store and update this set.

From another document (Space Science Instrumentation, vol. 5, no. 3, July 1981, D. Reidel Publ. Co., Dordrecht, NL, pages 247 - 256, S. Beros: "Microcomputer on-line data reductioons for satellite experiments") a microcomputer based data reduction system is known, which is intended for use on board satellites and balloons. After processing, only highly relevant data have to be stored on board or transmitted to Earth.

A method for data reduction from experimental histograms is also known from a document (Nuclear Instruments & Methods in Physics Research, vol. 220, no. 2, 3rd March 1984, Elsevier Science Publ. BV., Amsterdam, NL, pages 473 - 478, W.R. Falk: "Data reduction from experimental histograms") in which calculational methods of peak centroids and peak widths from histogram spectra where the peaks have full widths at half maximum as narrow as 2 or 3 channels are derived and evaluated.

The problem to be solved by the present invention is to take samples rather than analogue signals, and to process the signals to derive a reduced form constituted by a set of moments, and to store and update this set instead of the unprocessed signals.

This problem is solved by a method for storing intermittent functional faults of a physical system and for storing variables defining the context of these faults; whereby readings are taken, in a time window surrounding the presence of a predetermined fault, of predetermined variables, the variables being stored and the stored variables being updated at each of the successive manifestations of the intermittent fault, characterized in that samples of the read context variables are taken and in that for each of these variables there is computed the mean value and a moment representing a criterion of validity of the correlation between the manifestations of the fault and the mean value of the context variable in question.

A preferred variant of the method according to the invention is laid down in claim 2 and a device solving also the above mentioned problem is defined in claim 3.

Other characteristics and advantages of the method and of the device according to the invention will appear on reading the following description and on examining the appended drawing in which:

- Figure 1 is a block diagram of a first embodiment of the device according to the invention and,
- Figure 2 is a block diagram of a second embodiment of the device according to the invention.

The method according to the invention requires the processing of data relating, on the one hand, to the intermittent fault itself and, on the other hand, to a certain number of context variables whose possible correlations with the manifestations of the fault can be used to establish the origin of this fault and to then implement means of eliminating the fault.

With regard to the fault itself, the device for the implementation of the invention comprises means of detection of the appearance and of the disappearance of the intermittent fault, means of measuring the time intervals separating two successive appearances of the fault and the durations of this fault, means of computing "moments" such as the mean value and the variance of these two measurements, and means for storing and updating these measurements.

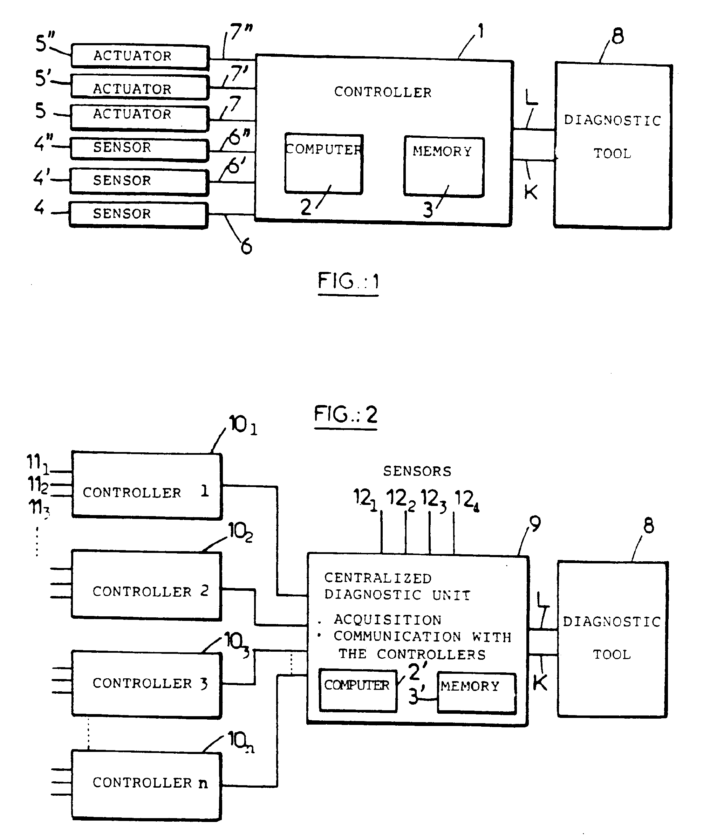

Figure 1 shows a first embodiment of a device for the implementation of the method according to the invention, in an application to motor vehicle electronics given by way of example.

An electronic control device installed in a motor vehicle conventionally comprises an electronic controller 1 provided with computing means 2 and with memory means 3, sensors 4, 4', 4",... and actuators 5, 5', 5",... connected to the controller 1 by inputs/outputs 6, 6', 6",... and 7, 7', 7",... respectively.

The controller 1 is conventionally provided with means of detection of its own failures and those of the sensors and actuators with which it is associated. The controller can thus change control strategy in order to take account of a possible failure of a sensor or of an actuator. It is thus for example that an anti-locking control device for the wheels of the vehicle can change strategy in order to take account of a detected failure of a wheel speed sensor, in such a way as to avoid taking into account erroneous data which could affect the braking safety of the vehicle.

In this way it is understood that the controller centralizes all of the data necessary for the acquisition of the instants of appearance and of disappearance- of various functional faults capable of affecting various units constituting a control and monitoring system.

According to the invention, starting from the acquisition of these instants, the computer can establish with the help of its own computing means, the number of functional faults having affected such and such a sensor, actuator or other unit of the vehicle monitored by the controller as well as "moments" such as the mean value and the variance or standard deviation, allowing the characteristics of all of the measurements of fault durations or of time intervals between successive faults detected and measured by the controller 1 to be concentrated in a reduced form. These same means of acquisition, computation and memory of the controller 1 finally allow the updating of the computed moments at each of the successive detections of new faults.

According to a characteristic of the method according to the invention this concentration in reduced form of updated moments, of a group of measured durations of faults and of intervals between faults, allows a considerable reduction in the size of the memories which would otherwise be necessary for storing all of the successively measured durations for the purpose of subsequent exploitation of these measurements. It also allows the definition, a priori, of the size of the memory section necessary for storing each moment, because the format of the latter can be predefined once and for all.

The device must also acquire and retain in memory data relating to the contexts in which the detected functional faults manifested themselves. It is therefore understood that it is possible to define, for each type of fault, the significant context variables to be taken into account. In a physical system such as a motor vehicle, it is understood for example that a failure of a wheel speed sensor has little chance of being able to be correlated with the temperature of the engine cooling fluid, whereas a correlation of such a failure with the accelerations/decelerations of the vehicle is possible, as will be seen below with the help of an example.

In the device of Figure 1, the context variables are acquired by the controller 1 by means of the sensors 4, 4', 4" connected to this controller. These sensors can be constituted by those intended to acquire the variables necessary for the controller to ensure the control of the actuators. They can be associated with other sensors acquiring other variables necessary for the definition of the context of appearance/disappearance of such and such a fault, without as such being necessary for the control of the actuators by the controller.

It would therefore be possible to continuously acquire the context variables measured by the sensors. Such a solution would require, in the controller, memories of prohibitive size, particularly in the case of mass-produced motor vehicle electronics. This solution furthermore implies acquisition of much useless data, as there is no need to know the state of the context variables apart from during the presence or the imminence of a fault, in order to diagnose the origin of the latter.

According to the present invention, the context variables are sampled only on the appearance and/or the disappearance of a fault.

According to a variant of the invention a looped memory is used (also called a "circulating" memory) for permanently storing the last $n$ samples of variables defining all of the contexts and, during the appearance of a fault, the particular variables capable of defining the context associated with this fault at instants prior to the instant of the failure are read from this memory.

According to another variant, the context variables are sampled throughout the entire duration of the fault. In this case it is possible to compact the collected data by computing moments of variables acquired during the duration of the fault (mean value, variance, etc) in order to place only these moments in the memory.

It is clear that the acquisition methods according to the invention described above allow a considerable limitation of the size of the memories necessary for retaining acquired samples.

According to an essential characteristic of the storage method according to the invention, moments (mean value, variance, etc) of the acquired samples are computed and only these moments are retained in memory. When a new fault occurs, the context definition variables of this new fault are acquired and subsequently processed as mentioned above in order to update the stored moments, only the updated values of these moments being retained in memory.

The size of the memory necessary for the retention of these updated moments is therefore reduced to very little and does not vary from one updating to the next. It can be predetermined by an evaluation of the maximum possible value of the moments in question, mean value or variance for example.

The cost of the memory space necessary for the implementation of the present invention is therefore very reduced and entirely compatible with the economic constraints of mass-production motor vehicle electronics. The reduced forms of the data thus stored however lends itself to a very efficient statistical analysis in order to achieve the sought result, namely the establishment of a sure diagnosis of the origin of an intermittent functional fault in such a way as to allow, by means of repairs determined by this diagnosis, the elimination of the observed fault.

Two indicators must be provided for storing a context variable; one indicator relating to the situation of the value of the variable and one indicator relating to the validity of the preceding indicator.

The indicator relating to the value of the context variable is obtained by computing, for example, the mean value of the samples of this variable successively acquired during each appearance and/or disappearance of the examined fault. This mean value will be truly representative of the variable if the conditions of appearance and of disappearance of the functiunal fault are of repetitive nature.

The other indicator must allow the evaluation of the validity of the mean value computed as mentioned above. This indicator is therefore obtained by computing the variance or standard deviation of the variable about the mean value. If the values of the acquired samples of the context variable in question are of a repetitive nature, the computed variance is then small and the mean value of the variable can be considered as indicative of a condition of appearance/disappearance of the examined fault. In the opposite case the value of the variance is large and the mean value of the parameter is not significant.

The data stored for a same type of fault can be established as follows:
- origin and type of fault;
- number of appearances of the fault between two garage inspections;
- instant of appearance if the event is unique or time interval between successive appearances of the fault if it is intermittent;
- variance of this time interval;
- mean duration of the presence of the fault;

## Example

The described application is in the field of motor vehicle electronics. There is used, for example, a storage device of the type shown in Figure 1, installed in a motor vehicle. The parameters relating to the fault and the context defined below are then stored in the memory means 3 of the controller 1. During a visit of the vehicle to the garage, the controller 1 is connected to a diagnostic device or "tool" 8 installed in the garage, by lines K and L which allow the transfer into this device of the contents of the part of the memory 3 which relates to a particular fault and to the context of appearance/disappearance of this fault. These contents can be called up by the garage mechanic, by means of a keyboard for example, in order to display the data and for the analysis of the displayed data by the garage mechanic himself for the purpose of determining the origin of the fault in question. As a variant, the diagnostic device could be programmed in such a way as to constitute an expert system cable of automatically determining this origin.

The case considered below is that of an analysis carried out by the garage mechanic himself. The data which he commands to be displayed in the device 8 are, by way of example, the following:

Origin of fault: engine control
Type of fault: water temperature sensor short-circuited
Number of appearances of the fault : 20
Mean interval between appearances : 180 min
Variance of the interval : 30000 min$^2$ (standard deviation 173 min)

4

Mean duration of the presence of the fault: 10 s
Variance of the duration : 225s$^2$ (standard deviation 15 s)

    variance of the duration;
- mean value and variance of each context variable when the fault appears;
- mean value and variance of each context variable when the fault disappears.

For convenience of vocabulary, the interval between successive appearances of the fault and the duration of the fault are assimilated throughout the present description as context variables.

The mean values and variances defined above are stored and updated on each appearance/disappearance of the fault by means of recurrent formulae implemented by the computing means 2 forming part of the controller 1. In this way there is avoided, according to the invention, the overloading of the memory means 3 which would otherwise result from a retention of all of the variable samples acquired and a final computation of the mean value and of the variance using all of the samples. The size of the memory necessary for the implementation of the invention being thus considerably reduced, it is compatible with the economic constraints of mass-production motor vehicle electronics, which is an essential advantage contributed by the present invention.

The mean value $\overline{X}$ and the variance $\sigma^2$ of a context variable can be updated at the instant (n+1) of appearance/disappearance of the fault which immediately follows the $\underline{n}$th appearance/disappearance of the fault by means of the following recurrent formulae:

$$\overline{X}_{n+1} = n.\overline{X}_n/(n+1) + x_{n+1}/(n+1)$$
$$\sigma^2_{n+1} = n.\sigma^2_n/(n+1) + n(\overline{X}_{n+1} - \overline{X}_n)^2/n+1 + (x_{n+1} - \overline{X}_{n+1})^2/(n+1)$$

where

$x_{n+1}$ = sampled value of the variable at the instant n+1, $\overline{X}_n$ and $\sigma^2_n$, are the mean value and variance of the variable at the instant n.

The efficiency of the diagnosis established by means of the storage method according to the invention will now be illustrated by an example.

## DEFINITION OF THE CONTEXT DURING THE APPEARANCE OF THE FAULT:

| | Air temperature | Engine speed | Vehicle speed | Acceleration |
|---|---|---|---|---|
| Mean Value | 30°C | 3500 rpm | 90 km/h | 0.8 m/s$^2$ |
| Variance | 800°C$^2$ | 9.10$^6$ rpm | 6400(Km/h)$^2$ | 0.04(m/s$^2$)$^2$ |
| Standard Deviation | 28°C | 3000 | 80 | 0.2 |

## DEFINITION OF THE CONTEXT WHEN THE
## FAULT DISAPPEARS:

|  | Air temperature | Engine speed | Vehicle speed | Acceleration |
|---|---|---|---|---|
| Mean Value | 32°C | 3600 rpm | 95 km/h | 0.6 m/s$^2$ |
| Variance | 820°C$^2$ | 9.10$^6$ rpm | 6300(Km/h)$^2$ | 0.03(m/s$^2$)$^2$ |
| Standard Deviation | 28°C | 3000 | 79 | 0.17 |

The above data reveal that the fault has a variable duration and that the period of appearance of the fault is variable. The analysis of the mean values and of the variances of the chosen context parameters allows the following observations to be made. With regard to the air temperature and the engine speed, it is observed that the standard deviation and the mean value are rather close which reveals that the fault appears over the entire normal range of variation of these parameters. The mean value of the vehicle speed, with regard to both the appearance and the disappearance of the fault, is high (90 to 95 km/hour), with a large standard deviation. The mean values of the acceleration of the vehicle, with regard both to the appearance and the disappearance of the fault, appear well defined because the standard deviation is relatively small in this case. This small standard deviation reveals a clear correlation of the appearance and of the disappearance of the fault with the passing of the vehicle through particular and rather high acceleration levels. Such accelerations are capable of displacing certain units in relation to one another because of their difference in inertia. Applied to a sensor, this observation causes consideration of an intermittent contact between a stripped section of its connecting cable to the controller with the chassis of the vehicle. The garage mechanic then knows that a replacement or repair of this cable must be undertaken as a matter of priority in order to attempt to eliminate the observed short-circuit of the cooling water temperature sensor of the engine.

Thus the garage mechanic has the means allowing him to diagnose an intermittent failure recorded while the vehicle is running, even though this same failure would not manifest itself physically in the garage.

From the above it is concluded that the use which is made, in the method according to the invention, of updated reduced forms of samples of variables related to the fault and to its context of appearance/disappearance, allows both the compression of the acquired data and the analysis of the latter for the purpose of determining the origin of the fault.

It should also be noted that if the analysis of the recorded data is not sufficient for the garage mechanic to be able to diagnose the failure he nevertheless has, thanks to the invention, a set of data relating to the context of appearance/disappearance of the failure which allows him to reproduce this context in the garage and to attempt to diagnose the failure by a direct observation of the behaviour of the units of the vehicle in this context which is favourable to the appearance of a failure.

The device according to the invention described in Figure 1 is designed to make use of means of acquisition, of computation and of memory contained in each of the controllers incorporated in a particular physical system. A local acquisition and processing of these data are thus performed. Transposed into a motor vehicle which can comprise, for example, a control unit for a wheel anti-locking device and an ignition and injection control unit associated with the engine, the invention then makes use of the computer and of the memories contained in each of these units for the acquisition and processing of fault data and of fault context data relating to the sensors and actuators controlled by each unit. As a variant, these units could also exploit data transmitted

6

between units by a communications bus between these units.

According to another embodiment of the device according to the invention, shown in Figure 2, the acquisition, processing and storage of data used in the invention are carried out in a centralized diagnostic unit 9 which communicates with n conventional controllers $10_1$, $10_2$, $10_3$, ... $10_n$. The unit 9 also manages the communications with the controllers in order to acquire the data to be collected, coming from sensors and actuators connected to each controller, by lines $11_1$, $11_2$, $11_3$, ... A centralized unit such as 9 can furthermore receive other context data through sensors connected directly to the unit by lines $12_1$, $12_2$, $12_3$ ... These sensors allow the unit 9 to sample context variables which are inaccessible by the controllers in order to complete the description of the context. The unit 9 comprises computation means (2') and memory means (3') which carry out the functions of computation, storage and updating of the "moments" of the acquired context variables. The unit 9 can furthermore be connected to a diagnostic device or "tool" 8 installed in the garage, just like the one shown in Figure 1. The centralization of the means of computation and of memory of the unit 9 allows in particular, the controllers $10_1$ to $10_n$ to share this memory, which allows a further reduction in its total size.

## Claims

1. Method for storing intermittent functional faults of a physical system and for storing variables defining the context of these faults; whereby readings are taken, in a time window surrounding the presence of a predetermined fault, of predetermined variables, the variables being stored and the stored variables being updated at each of the successive manifestations of the intermittent fault, characterized in that samples of the read context variables are taken and in that for each of these variables there is computed the mean value and a moment representing a criterion of validity of the correlation between the manifestations of the fault and the mean value of the context variable in question.

2. Method according to claim 1, characterized in that the moment representing the criterion of validity is the variance or standard deviation of the context variable in question.

3. Device for the implementation of the method according to Claim 1, comprising a centralized unit (9) for processing and storing data acquired from several controllers ($10_1$, $10_2$, $10_3$,...), these controllers being associated with sensors and with particular actuators ($11_1$, $11_2$, $11_3$,...) in order to control a part of the physical system, characterized in that the device comprises means of acquisition ($12_1$, $12_2$, $12_3$,...) of context variables which are not accessible by the sensors associated with the controllers, these means of acquisition being connected directly to the centralized unit.

## Patentansprüche

1. Verfahren zur Speicherung intermittierender funktioneller Fehler eines physikalischen Systems und zur Speicherung von Variablen, welche den Kontext dieser Fehler definieren, wobei in einem die Gegenwart eines vorbestimmten Fehlers umgebenden Zeitfensters Ablesungen der vorbestimmten Variablen vorgenommen werden, die Variablen gespeichert und die gespeicherten Variablen bei jeder der aufeinanderfolgenden Manifestierungen des intermittierenden Fehlers auf den neuesten Stand gebracht werden, dadurch gekennzeichnet, daß Proben der Lesekontextvariablen genommen werden und daß für jede dieser Variablen der Durchschnittswert und ein Moment berechnet werden, das ein Kriterium für die Genauigkeit der Beziehung zwischen den Manifestierungen des Fehlers und des Durchschnittswertes der fraglichen Kontextvariable darstellt.

2. Verfahren nach Anspruch 1, dadurch gekennzeichnet, daß das Moment, welches das Kriterium der Genauigkeit darstellt, die Varianz oder die Standardabweichung der fraglichen Kontextvariablen ist.

3. Vorrichtung für die Durchführung des Verfahrens nach Anspruch 1, mit einer zentralisierten Einheit (9) zur Verrechnung und Speicherung von Daten, die von verschiedenen Steuergeräten ($10_1$, $10_2$, $10_3$, ...) aufgenommen wurden, wobei diesen Steuergeräten Sensoren und besondere Betätigungsvorrichtungen ($11_1$, $11_2$, $11_3$, ...) zugeordnet sind, um einen Teil des physikalischen Systems zu steuern, dadurch gekennzeichnet, daß die Vorrichtung Erfassungsmittel ($12_1$, $12_2$ $12_3$, ...) der Kontextvariablen aufweist, die den Sensoren, welche den Steuergeräten zugeordnet sind, nicht zugänglich sind, wobei diese Erfassungsmittel direkt mit der zentralisierten Einheit verbunden sind.

**Revendications**

1.  Procédé de mémorisation de défauts de fonctionnement intermittent d'un système physique et de variables de définition du contexte de ces défauts, suivant lequel, on lit dans une fenêtre temporelle entourant la présence d'un défaut prédéterminé, des variables prédéterminées, les variables étant mémorisées et les variables mémorisées étant actualisées à chacune des manifestations successives du défaut intermittent, caractérisé en ce que des échantillons des variables de contexte lues sont prélevés et en ce que, pour chacune de ces variables on calcule la valeur moyenne et un moment représentatif d'un critère de validité de la corrélation entre les manifestations du défaut et la valeur moyenne de la variable de contexte en question.

2.  Procédé conforme à la revendication 1, caractérisé en ce que le moment représentatif du critère de validité est la variance ou l'écart-type de la variable de contexte considérée.

3.  Dispositif pour la mise en oeuvre du procédé conforme à la revendication 1, comprenant une unité centralisée (9) de traitement et de mémorisation de données acquises de plusieurs contrôleurs ($10_1$, $10_2$, $10_3$.....), ces contrôleurs étant associés à des capteurs et à des actionneurs particuliers ($11_1$, $11_2$, $11_3$.....) pour commander une partie du système physique, caractérisé en ce que le dispositif comprend des moyens d'acquisition ($12_1$, $12_2$, $12_3$.....) de variables de contexte qui ne sont pas accessibles par les capteurs associés aux contrôleurs, ces moyens d'acquisition étant connectés directement à l'unité centralisée.

FIG.: 1

FIG.: 2